# FASCICULE DE BREVET EUROPEEN

(11) **EP 0 450 245 B1**
(45) Date de publication et mention de la délivrance du brevet: **24.03.1993**
(21) Numéro de dépôt: 90403477.4
(22) Date de dépôt: 06.12.1990
(51) Int. Cl.: G01R 19/12, G11C 5/14, G06F 11/14

(54) **Détecteur de variation rapide d'alimentation de circuit intégré**
Nachweisgerät für schnelle Schwankungen der Versorgungsspannung einer integrierten Schaltung
Detector for rapid variations of the supply voltage of an integrated circuit

(30) Priorité: 08.12.1989 FR 8916296
(43) Date de publication de la demande: 09.10.1991
(73) Titulaire: SGS-THOMSON MICROELECTRONICS S.A., 94250 Gentilly (FR)
(72) Inventeur: Fruhauf, Serge, F-75116 Paris (FR); Breugnot, Frédéric, F-75116 Paris (FR)
(74) Mandataire: Schmit, Christian Norbert Marie

(56) Documents cités:
- FR-A- 2 449 898
- US-A- 4 173 756
- US-A- 4 706 157
- US-A- 4 717 840
- PATENT ABSTRACTS OF JAPAN, vol. 7, no. 23 (P-171)[1168], 29 janvier 1983; & JP-A-57 175 261 (MITSUBISHI DENKI K.K.) 28-10-1982

## Description

L'invention concerne les circuits intégrés, et plus précisément un détecteur de variations de la tension d'alimentation Vcc d'un circuit intégré, ce détecteur faisant partie du circuit intégré lui-même.

Dans certaines applications, et tout particulièrement dans les applications nécessitant une confidentialité ou une sécurité de stockage des informations mémorisées dans le circuit intégré ou traitées dans ce circuit, on s'est aperçu que l'on pouvait frauduleusement accéder à ces informations confidentielles et éventuellement les modifier en agissant sur la tension d'alimentation Vcc du circuit. On peut imaginer par exemple que les circuits de protection de la confidentialité ne fonctionnent plus correctement au delà d'une certaine valeur de tension d'alimentation.

Les applications de ce type sont de plus en plus nombreuses et sont illustrées notamment par les circuits intégrés montés dans des cartes à puces, clés à puces etc., ces circuits étant fréquemment associés à des applications où la confidentialité et la sécurité sont recherchées.

Certains de ces circuits ont été pourvus de détecteurs de montée anormale de la tension Vcc au dessus de sa valeur nominale ou au dessus de la plage de valeurs nominales autorisées en fonctionnement normal. Lorsque le détecteur voit la tension Vcc dépasser par exemple de 20% la valeur nominale (en général 5 volts), il envoie un signal interdisant tout ou partie du fonctionnement du circuit intégré.

Les détecteurs utilisés pour cela sont des détecteurs à seuil, dont le seuil est choisi en fonction de la limite acceptable pour Vcc. Un tel détecteur à seuil est décrit dans le brevet US 4,717,840. Ils remplissent en général correctement leur fonction.

Mais on s'est aperçu qu'il y a des cas où la fonction n'est plus correctement remplie, le détecteur ne réagissant pas de la manière désirée aux variations de tension d'alimentation.

L'invention propose dans le circuit intégré un détecteur de variations rapides de la tension d'alimentation selon la revendication 1. Ce détecteur sert à modifier ou interdire le fonctionnement de tout ou partie d'un circuit intégré lorsque la tension d'alimentation de ce circuit subit des variations rapides d'amplitude importante.

En effet, l'invention réside d'abord dans la remarque que la sécurité peut ne plus fonctionner correctement lorsqu'un fraudeur applique non pas un dépassement franc de la tension d'alimentation mais une variation rapide de celle-ci, variation qu'un détecteur classique à seuil n'a pas le temps de détecter.

L'invention propose une réalisation de détecteur de variations rapides de la tension, qui permet d'améliorer la sécurité par rapport aux systèmes existants.

Le détecteur de variations de tension d'alimentation selon l'invention comporte principalement une capacité, un moyen pour charger cette capacité par la tension d'alimentation avec un limiteur de courant de charge ou décharge de cette capacité, et un moyen pour appliquer à un transistor de détection la différence entre la tension d'alimentation et la tension aux bornes de la capacité.

Le limiteur de courant fait que la tension de la capacité ne suit pas immédiatement les variations de tension d'alimentation. Il en résulte une tension de décalage que l'on applique au transistor de détection pour modifier sa conduction. En pratique, on rendra conducteur le transistor s'il ne l'était pas, ou on le rendra non conducteur s'il était conducteur.

Ce circuit permet de détecter des variations rapides de tension d'alimentation (mais pas des variations très lentes), si ces variations sont suffisamment importantes. Il n'y a pas véritablement de seuil absolu d'amplitude pour laquelle le détecteur réagit. En effet, un signal de détection est produit en fonction de l'amplitude de la variation de la tension d'alimentation, mais en prenant en compte la vitesse de variation. On pourra définir un seuil d'amplitude de variation faisant réagir le détecteur dans le cas où la variation est très rapide devant la constante de temps de charge de la capacité. Ce seuil pourra être par exemple de 10 à 20% environ de la valeur de la tension.

Pour détecter des variations rapides alternées vers le haut et vers le bas, on pourra dupliquer le circuit avec deux capacités et deux transistors de détection, dont l'un détecte une tension de décalage lors de la charge d'une capacité, et l'autre détecte une tension de décalage due à la décharge d'une autre capacité, la charge et la décharge résultant l'une de l'augmentation de la tension d'alimentation et l'autre de sa diminution.

Cependant, pour économiser une capacité on préférera utiliser une capacité unique, un premier transistor de détection ayant sa source reliée à la tension d'alimentation et sa grille reliée à la capacité, et un deuxième transistor de détection ayant sa source reliée à la capacité et sa grille reliée à une tension qui varie directement avec la tension d'alimentation.

Dans un exemple de réalisation, le limiteur de courant de charge de la capacité est un troisième transistor monté en diode, relié entre la tension d'alimentation Vcc et la grille du premier transistor, et établissant entre sa source et son drain une tension de seuil. Le deuxième transistor a alors de préférence sa grille reliée à la tension d'alimentation Vcc par un quatrième et un cinquième transistors de même type que le troisième, en série et montés en diodes; on s'arrange pour qu'il s'établisse aux bornes de l'ensemble série une tension de seuil sensiblement double de la tension de seuil du troisième transistor. Le potentiel de grille du deuxième transistor en régime permanent est alors égal à la tension d'alimentation Vcc diminuée de cette double tension de seuil. Simultanément, le potentiel de grille du premier transistor est égal à la tension d'alimentation Vcc diminuée de la tension de seuil du troisième transistor.

Le premier et le deuxième transistors sont de préférence tous deux de type opposé au troisième. Le circuit fonctionne alors par suite de la différence entre la tension de seuil du limiteur (plus faible) et la tension de seuil des transistors de détection (plus forte).

On prévoit par ailleurs de préférence une source de courant de décharge de la capacité si le limiteur est monté de manière à ne laisser passer un courant de charge de la capacité que dans un seul sens (que ce soit une charge ou une décharge).

On prévoit aussi une source de courant de polarisation des quatrième et cinquième transistors.

Pour l'exploitation des changements de conduction des premier et deuxième transistors, on prévoit de préférence que la mise en conduction du premier transistor de détection sert à déclencher une première bascule et à restaurer l'état d'une deuxième bascule, et que réciproquement la mise en conduction du deuxième transistor de détection déclenche la deuxième bascule et restaure la première. A partir des signaux de sortie des deux bascules, on peut commander comme on le désire le circuit intégré, notamment pour empêcher tout ou partie de son fonctionnement.

D'autres caractéristiques et avantages de l'invention apparaîtront à la lecture de la description détaillée qui suit et qui est faite en référence aux dessins annexés dans lesquels :
- la figure 1 représente un schéma d'un mode de réalisation simple de l'invention;
- la figure 2 représente un schéma d'un mode de réalisation plus complexe;
- la figure 3 représente un diagramme temporel de signaux dans le circuit de la figure 2.

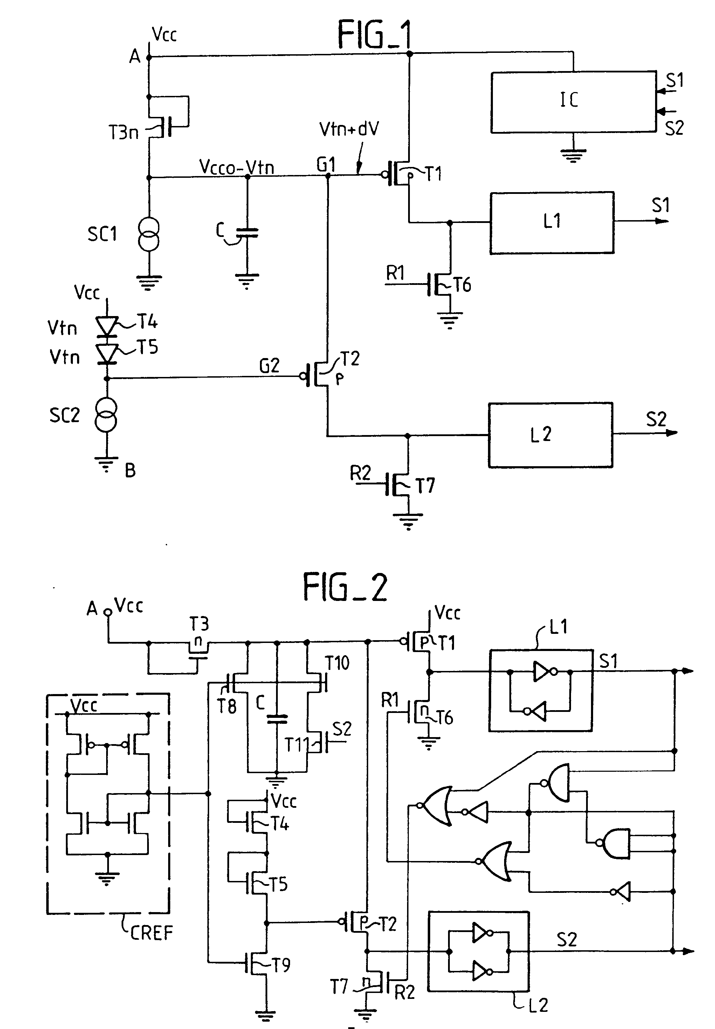

Le détecteur selon l'invention, représenté à la figure 1 est destiné à être incorporé à un circuit intégré plus général IC alimenté par une tension d'alimentation Vcc entre deux bornes A et B; le circuit IC est représenté symboliquement sur la figure par un bloc rectangulaire. La borne B est une borne de masse et la borne A est une borne au potentiel Vcc. Le but du circuit est de détecter des variations rapides de la tension d'alimentation Vcc, pour modifier ou interrompre tout ou partie du fonctionnement du circuit général IC lorsque la tension Vcc subit des variations rapides d'amplitude suffisante.

Le circuit comprend une capacité C susceptible d'être chargée par la tension Vcc à travers un limiteur de courant. Le limiteur de courant est ici un transistor T3 monté en diode, c'est-à-dire avec sa grille connectée à son drain. Le drain est connecté à Vcc (borne A), et la source est connectée à un côté de la capacité, l'autre côté de la capacité étant à la masse (borne B). Avec ce montage, le transistor T3 est à canal N pour une tension Vcc positive. Le transistor T3 établit une chute de tension Vtn entre ses bornes si Vtn est la tension de seuil de ce transistor. Vtn dépend de la technologie utilisée.

Le circuit fonctionnerait aussi si la tension de charge de la capacité était une fraction de la tension d'alimentation générale du circuit intégré plutôt que la tension d'alimentation elle-même.

Une source de courant SC1 est connectée en parallèle avec la capacité. Elle permet la décharge de la capacité lorsque la tension Vcc diminue au dessous d'une certaine valeur (la capacité ne peut pas se décharger à travers le transistor T3 monté en diode).

En régime d'alimentation Vcc stable, la capacité reste chargée en permanence à une tension qui est sensiblement Vcco-Vtn, où Vcco est la valeur stable de Vcc et Vtn est la tension de seuil du transistor T3. L'écart de potentiel entre la borne A (à Vcco) et la tension de la capacité est égal à Vtn, c'est-à-dire à la chute de tension introduite par le limiteur.

Lorsque Vcc varie rapidement dans le sens de la montée, la capacité tend à maintenir à ses bornes la tension Vcco-Vtn, du fait de la présence du limiteur de courant et des autres résistances du circuit qui empêchent une charge instantanée de la capacité. Le retard entre la variation de Vcc et la variation de potentiel aux bornes de la capacité se traduit par une différence de potentiel supplémentaire entre la borne A (à Vcc) et la tension de la capacité (Vcco-Vtn).

Si Vcc = Vcco + dV, c'est-à-dire si Vcc a varié brusquement en positif de dV, l'écart de tension est maintenant de Vtn+dV, à condition toutefois que la variation de Vcc soit très rapide devant le temps de recharge de la capacité. Si la variation est plus lente, on comprendra que dV représente plus précisément une fraction de la variation de la tension d'alimentation Vcc.

On se sert de cette variation de tension de Vtn à Vtn+dV pour rendre conducteur un transistor de détection T1 qui était bloqué auparavant.

Le transistor de détection T1 est un transistor à canal P, ayant sa grille connectée à la capacité (point G1) et sa source connectée à Vcc (borne A). Le transistor a une tension de seuil Vtp telle que le transistor soit bloqué lorsque Vcc reste stable, c'est-à-dire lorsque la tension Vtn est présente entre la borne A (source de T1) et le point G1 (grille de T1), et qu'il soit au contraire conducteur quand une tension dV vient se rajouter à Vtn entre grille et source. Par conséquent, dans cette réalisation, la technologie doit être telle que la tension de seuil Vtp du transistor à canal P T1 soit plus forte que la tension de seuil Vtn du transistor T3, et moins forte que Vtn+dV.

Le transistor T3 peut, s'il le faut, être déplété pour avoir une tension de seuil réduite par rapport aux autres transistors à canal N du circuit intégré.

Le transistor T1 se mettra à conduire si l'écart de tension dV produit par la montée brusque de Vcc est tel que Vtn+dV devienne supérieur à Vtp, alors que Vtn est inférieur à Vtp. Il faut donc que la variation de Vcc soit assez rapide pour que la tension aux bornes de la capacité n'ait pas le temps de suivre la variation de Vcc et pour qu'une tension de décalage dV suffisante soit produite.

Le montage utilise donc le fait qu'il y a une différence entre les tensions de seuil des transistors T1 et T3 (tensions de seuil prises en valeur absolue).

La mise en conduction du transistor T1 est utilisée pour déclencher une bascule L1 qui fournit à sa sortie un signal S1 indiquant une montée brusque de Vcc. Un transistor auxiliaire T6 permet de restaurer la bascule dans son état initial sous la commande d'un signal de restauration R1. Le signal S1 est utilisable pour interrompre ou modifier le fonctionnement de tout ou partie du circuit intégré IC.

On comprendra que la capacité a forcément une valeur limitée et par conséquent, si la variation de Vcc est trop lente, la tension aux bornes de la capacité suivra les variations de Vcc et ne déclenchera pas la mise en conduction du transistor de détection T1.

Plutôt que d'utiliser une autre capacité et un montage symétrique pour détecter également une chute rapide de la tension Vcc, on préfère utiliser une astuce de circuit.

Un deuxième transistor de détection, de type P comme T1 et de même tension de seuil Vtp, a sa source connectée au point G1, c'est-à-dire à la capacité C, et il a sa grille connectée à un point G2 de potentiel Vcc-2Vtn. Ceci est obtenu en connectant entre la borne A (à Vcc quel que soit Vcc) et le point G2 deux transistors T4 et T5 de même type et de même tension de seuil que T3, montés en diode et établissant entre leur source et leur drain une tension de seuil Vtn chacun. Les transistors T4 et T5 sont montés chacun avec sa grille reliée à son drain. Ils sont en série entre la borne A et le point G2 pour établir entre les deux points une chute de tension 2Vtn. Une source de courant SC2 entre le point G2 et la masse assure le passage d'un courant permanent dans les transistors T4 et T5 pour maintenir cette chute de tension 2 Vtn. Les transistors T4 et T5 pourraient être remplacés par un autre montage établissant une tension de seuil de 2Vtn ou à peu près, par exemple un seul transistor monté en diode, non déplété, peut convenir si sa tension de seuil est de l'ordre du double de celle du transistor T3.

Le potentiel de G2 est donc Vcc-2Vtn quel que soit Vcc.

En régime permanent (Vcc stable et égal à une valeur Vcco par exemple), le potentiel de source du deuxième transistor de détection T2 est Vcco-Vtn (tension aux bornes de la capacité); le potentiel de grille est Vcco-2Vtn. Il y a donc Vtn entre grille et source. Le deuxième transistor de détection T2 est donc bloqué, la tension Vtn entre grille et source étant inférieure à sa tension de seuil Vtp.

Lorsque Vcc varie rapidement dans le sens de la baisse, la tension de la capacité ne suit pas instantanément et reste temporairement à Vcco-Vtn. Le décalage dV résultant de la variation rapide de Vcc et de la stabilité relative de la tension de source de T2 se traduit par l'apparition d'une tension Vtn+dV entre grille et source du deuxième transistor de détection. Celui-ci devient conducteur dès que le décalage dV dépasse un seuil, et plus précisément dès que Vtn+dV dépasse la tension de seuil Vtp de ce transistor.

La mise en conduction du deuxième transistor de détection déclenche le basculement d'une deuxième bascule L2 qui fournit à sa sortie un signal S2 indiquant une variation rapide vers le bas de la tension d'alimentation Vcc. Les signaux S2 issus de la bascule L2 sont utilisés comme les signaux S1 ou en combinaison avec les signaux S1 (selon les cas) pour déclencher une modification de fonctionnement ou une interruption de tout ou partie du circuit intégré IC. Un transistor T7, commandé par un signal de restauration R2 permet de restaurer la bascule dans son état initial lorsqu'on le désire.

Comme on le voit, le circuit détecte symétriquement une baisse et une montée rapide de la tension Vcc. Le fonctionnement repose sur la différence entre la tension de seuil Vtn du transistor limiteur de courant T3 et la tension de seuil Vtp des transistors de détection T1 et T2.

On peut facilement vérifier que lorsque la tension Vcc baisse, il n'y a pas de mise en conduction de T1, alors que lorsque la tension Vcc monte, il n'y a pas de mise en conduction de T2. La source de courant SC1 permet que la capacité C se décharge lorsque la tension baisse.

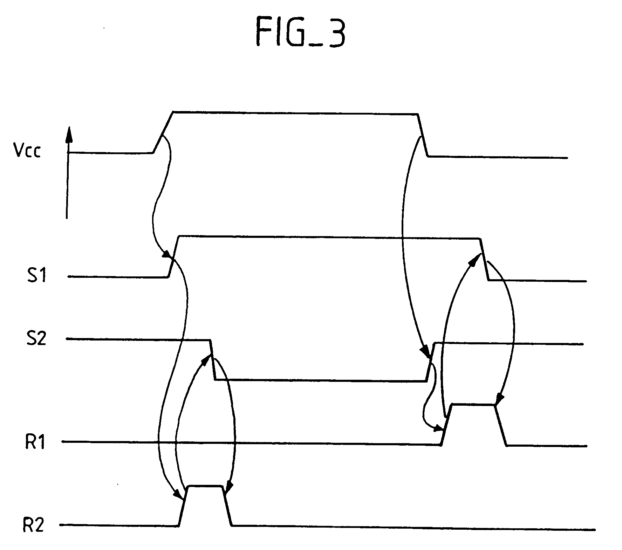

La figure 2 représente une réalisation plus détaillée. Les éléments déjà décrits et portant les mêmes références qu'à la figure 1 ne seront pas redécrits.

Les sources de courant du schéma sont des transistors dont la base est commandée par un circuit commun de référence CREF. Ce circuit est un double miroir de courant classique fournissant une tension de polarisation Vpol qui est appliquée aux bases des différents transistors servant de source de courant.

En particulier, la source de courant SC1 est un transistor T8 ainsi commandé par Vpol. La source de courant SC2 est un transistor T9 commandé par Vpol.

Une autre source de courant (transistor T10 commandé par Vpol) est placée en série avec un transistor de commutation T11, le tout en parallèle sur la capacité C. Le transistor T11 est rendu conducteur par le signal S2 déclenché lors d'une baisse rapide de Vcc. Il permet la mise en parallèle de deux sources de courant lors d'une baisse rapide de Vcc pour accélérer la décharge de la capacité.

Enfin, dans ce schéma de la figure 2, on a montré un circuit logique à deux portes NAND, deux portes NOR et deux inverseurs, recevant les signaux S1 et S2 et élaborant les signaux de restauration R1 et R2 de la bascule L1 et de la bascule L2 respectivement.

La figure 3 représente l'explication de ce circuit logique sous forme d'un diagramme temporel de signaux, avec les relations de cause à effet (flèches courbes) entre les différents signaux.

Une montée rapide de Vcc déclenche le basculement de S1 qui déclenche alors le signal de restauration R2. Le signal S2 est remis à zéro par R2 et déclenche ensuite lui-même la remise à zéro de R2. Une descente rapide de Vcc déclenche le signal S2 qui déclenche le signal de restauration R1. Le signal S1 est alors remis à zéro et déclenche ensuite la remise à zéro de R2.

## Revendications

1. Circuit intégré comprenant un détecteur de variations de la tension d'alimentation (Vcc) du circuit pour modifier ou interrompre tout ou partie du fonctionnement du circuit intégré, le détecteur comportant une capacité (C), un moyen pour charger cette capacité (C) à partir de la tension d'alimentation (Vcc) avec un limiteur (T3) de courant de charge de cette capacité (C), un moyen pour appliquer à un transistor de détection (T1, T2) la différence entre la tension d'alimentation (Vcc) et la tension aux bornes de la capacité (C), le limiteur de courant étant un transistor (T3) ayant sa grille reliée à son drain caractérisé en ce que la grille du transistor (T3) du limiteur de charge est reliée à la tension d'alimentation (Vcc), et sa source est reliée à la capacité (C), que le transistor (T3) du limiteur de courant est de type de conductivité opposé au transistor de détection (T1, T2) et a une tension de seuil (Vtn) plus faible en valeur absolue que la tension de seuil (Vtp) du transistor de détection.

2. Circuit selon la revendication 1, caractérisé en ce que le détecteur comporte un premier transistor de détection (T1) ayant sa source reliée à la tension d'alimentation (Vcc) et sa grille reliée à la capacité (C), et un deuxième transistor de détection (T2) ayant sa source reliée à la capacité et sa grille reliée à une tension qui varie directement avec la tension d'alimentation (Vcc).

3. Circuit selon la revendication 2, caractérisé en ce que le deuxième transistor (T2) a sa grille reliée à la tension d'alimentation (Vcc) par un quatrième et un cinquième transistors de même type de conductivité et de même tension de seuil que le transistor (T3) du limiteur de courant, en série et montés en diodes pour établir sur la grille du deuxième transistor de détection une tension Vcc-2Vtn, où Vcc est la tension d'alimentation et Vtn est la tension de seuil de chacun de ces transistors en série.

4. Circuit selon l'une des revendications 1 à 3, caractérisé en ce que le limiteur ne laisse passer le courant de charge que dans un seul sens vers la capacité, et en ce qu'on prévoit en outre une source de courant (SC1) de décharge de la capacité.

5. Circuit selon l'une des revendications 1 à 4, caractérisé en ce que la mise en conduction du premier transistor de détection sert à déclencher une première bascule (L1) et à restaurer l'état d'une deuxième bascule (L2), et en ce que réciproquement la mise en conduction du deuxième transistor de détection déclenche la deuxième bascule et restaure la première.

## Patentansprüche

1. Integrierte Schaltung mit einem Detektor für Änderungen der Versorgungsspannung (Vcc) der Schaltung, um die Funktion der integrierten Schaltung ganz oder teilweise zu modifizieren oder zu unterbrechen, welcher Detektor eine Kapazität (C), ein Mittel zum Laden dieser Kapazität (C) ausgehend von der Versorgungsspannung (Vcc) mit einem Begrenzer (T3) für den Ladestrom dieser Kapazität (C), und ein Mittel zum Anlegen der Differenz zwischen der Versorgungsspannung (Vcc) und der Klemmenspannung der Kapazität (C) an einen Detektortransistor (T1, T2) aufweist, wobei der Strombegrenzer ein Transistor (T3) ist, dessen Gate mit seinem Drain verbunden ist, **dadurch gekennzeichnet**, daß das Gate des Transistors (T3) des Ladebegrenzers an die Versorgungsspannung (Vcc) angeschlossen ist und seine Source mit der Kapazität (C) verbunden ist, und daß der Transistor (T3) des Strombegrenzers vom entgegengesetzten Leitungstyp wie der Detektortransistor (T1, T2) ist und eine Schwellenspannung (Vtn) aufweist, die dem Absolutwert nach kleiner ist als die Schwellenspannung (Vtp) des Detektortransistors.

2. Schaltung nach Anspruch 1, **dadurch gekennzeichnet,** daß der Detektor einen ersten Detektortransistor (T1), dessen Source mit der Versorgungsspannung (Vcc) und dessen Gate mit der Kapazität (C) verbunden ist, und einen zweiten Detektortransistor (T2) aufweist, dessen Source mit der Kapazität und dessen Gate mit einer Spannung verbunden ist, die sich direkt mit der Versorgungsspannung (Vcc) ändert.

3. Schaltung nach Anspruch 2, **dadurch gekennzeichnet,** daß das Gate des zweiten Transistors (T2) mit der Versorgungsspannung (Vcc) über einen vierten und fünften Transistor verbunden ist, die denselben Leitungstyp und dieselbe Schwellenspannung aufweisen, wie der Transistor (T3) des Strombegrenzers, die in Reihe liegen und als Dioden geschaltet sind, um am Gate des zweiten Detektortransistors eine Spannung Vcc - 2Vtn einzustellen, wobei Vcc die Versorgungsspannung und Vtn die Schwellenspannung jedes der in Reihe liegenden Transistoren ist.

4. Schaltung nach einem der Ansprüche 1 bis 3, **dadurch gekennzeichnet,** daß der Begrenzer den Ladestrom nur in einer Richtung zur Kapazität fließen läßt, und daß des weiteren eine Stromquelle (SC1) zum Entladen der Kapazität vorgesehen ist.

5. Schaltung nach einem der Ansprüche 1 bis 4, **dadurch gekennzeichnet,** daß das Überführen des ersten Detektortransistors in den leitenden Zustand dazu dient, eine erste Kippschaltung (L1) zu triggern und den Zustand einer zweiten Kippschaltung (L2) rückzusetzen, und daß umgekehrt das Überführen des zweiten Detektortransistors in den leitenden Zustand die zweite Kippschaltung triggert und die erste rücksetzt.

## Claims

1. An integrated circuit comprising a detector of variations in the supply voltage (Vcc) of the circuit in order to alter or interrupt all or part of the operation of the integrated circuit, said detector comprising a capacitor (C), a means for charging this capacitor (C) from the supply voltage (Vcc) with a limiter (T3) of the current for charging said capacitor (C), a means for applying to a detection transistor (T1, T2) the difference between the supply voltage (Vcc) and the voltage across the terminals of the capacitor (C), the current limiter being a transistor (T3) which has its gate connected to its drain, characterized in that the gate of the charge limiting transistor (T3) is connected to the supply voltage (Vcc) and its source is connected to the capacitor (C), and in that the current limiter transistor (T3) is of an opposite conductivity type to that of the detection transistor (T1, T2) and has a lower threshold voltage (Vtn), in absolute value terms, than the threshold voltage (Vtp) of the detection transistor.

2. A circuit according to claim 1, characterized in that the detector includes a first detection transistor (T1) having its source connected to the supply voltage (Vcc) and its gate connected to the capacitor (C) and a second detection transistor (T2) having its source connected to the capacitor (C) and its gate connected to a voltage which varies directly with the supply voltage (Vcc).

3. A circuit according to claim 2, characterized in that the second transistor (T2) has its gate connected to the supply voltage (Vcc) through a fourth and a fifth transistor of the same conductivity type and the same threshold voltage as the current limiter transistor (T3) and connected in series as diodes to establish a voltage Vcc-2Vtn on the gate of the second detection transistor, where Vcc is the supply voltage and Vtn is the threshold voltage of each of said series-connected transistors.

4. A circuit according to any one of claims 1 to 3, characterized in that the limiter allows the charge current to pass in only one direction towards the capacitor, and in that a current source (SC1) is also provided for discharging the capacitor.

5. A circuit according to any one of claims 1 to 4, characterized in that the turning on of the first detection transistor is used to trigger a first flip-flop (L1) and to restore the state of a second flip-flop (L2), and in that, reciprocally, the turning on of the second detection transistor triggers the second flip-flop and restores the state of the first.
